# DEMANDE DE BREVET EUROPEEN

(11) **EP 4 685 550 A1**
(43) Date de publication de la demande: **28.01.2026**
(21) Numéro de dépôt: 25190464.5
(22) Date de dépôt: 18.07.2025
(51) Int. Cl.: G02F 1/01, G02F 1/31

(54) **COMMUTATEUR A BASE DE MATERIAU A CHANGEMENT DE PHASE**

(30) Priorité: 26.07.2024 FR 2408331
(71) Demandeur: Commissariat à l'Energie Atomique et aux Energies Alternatives, 75015 Paris (FR); Université Grenoble Alpes, 38400 Saint-Martin-d'Hères (FR); Institut Polytechnique de Grenoble, 38000 Grenoble (FR)
(72) Inventeur: NAOUI, Ayoub, 38054 GRENOBLE CEDEX 09 (FR); CHARLET, Ismaël, 38054 GRENOBLE CEDEX 09 (FR)
(74) Mandataire: Cabinet Beaumont

(57) **Abrégé**

La présente description concerne un commutateur (200) à base d'un matériau à changement de phase comprenant :
- une région (103) en ledit matériau à changement de phase reliant des première (101A) et deuxième (101B) électrodes de conduction du commutateur ;
- un guide d'ondes (105) situé à l'aplomb de la région en ledit matériau à changement de phase et comprenant une région centrale (107) en un premier matériau présentant un premier indice de réfraction entourée d'une région périphérique (109) en un deuxième matériau présentant un deuxième indice de réfraction inférieur au premier indice de réfraction ; et
- une région (201) en un troisième matériau présentant un troisième indice de réfraction inférieur au deuxième indice de réfraction et située dans la région périphérique du guide d'ondes à l'aplomb d'une première face de la région centrale du guide d'ondes opposée à la région en ledit matériau à changement de phase.

## Description

### Domaine technique

La présente description concerne de façon générale les dispositifs électroniques. La présente description concerne plus particulièrement les commutateurs à base d'un matériau à changement de phase, capable d'alterner entre une phase cristalline, électriquement conductrice, et une phase amorphe, électriquement isolante.

### Technique antérieure

Diverses applications tirent profit de commutateurs, ou interrupteurs, à base d'un matériau à changement de phase pour permettre ou empêcher une circulation d'un courant électrique dans un circuit. De tels commutateurs peuvent notamment être mis en œuvre dans des applications de communication radiofréquence, par exemple pour commuter une antenne entre des modes d'émission et de réception, activer un filtre correspondant à une bande de fréquences, etc.

Les commutateurs à base d'un matériau à changement de phase existants présentent toutefois divers inconvénients.

### Résumé de l'invention

Il serait souhaitable de pallier tout ou partie des inconvénients des commutateurs à base d'un matériau à changement de phase existants.

Pour cela, un mode de réalisation prévoit un commutateur à base d'un matériau à changement de phase comprenant :
- une région en ledit matériau à changement de phase reliant des première et deuxième électrodes de conduction du commutateur ;
- un guide d'ondes situé à l'aplomb de la région en ledit matériau à changement de phase et comprenant une région centrale en un premier matériau présentant un premier indice de réfraction entourée d'une région périphérique en un deuxième matériau présentant un deuxième indice de réfraction inférieur au premier indice de réfraction ; et
- une région en un troisième matériau présentant un troisième indice de réfraction inférieur au deuxième indice de réfraction et située dans la région périphérique du guide d'ondes à l'aplomb d'une première face de la région centrale du guide d'ondes opposée à la région en ledit matériau à changement de phase.

Selon un mode de réalisation, la région en ledit troisième matériau s'étend depuis la première face de la région centrale du guide d'ondes.

Selon un mode de réalisation, la région en ledit troisième matériau est une cavité au moins partiellement remplie d'une ou plusieurs substances solides, liquides ou gazeuses, de préférence une cavité remplie d'air.

Selon un mode de réalisation, la région en ledit troisième matériau présente, en vue de dessus, une forme fuselée s'évasant le long d'une direction de propagation d'un signal optique de commande du commutateur.

Selon un mode de réalisation, la région en ledit matériau à changement de phase présente une largeur de l'ordre d'une ou plusieurs dizaines de micromètres, de préférence comprise entre 10 et 100 µm, plus préférentiellement comprise entre 30 et 100 µm.

Selon un mode de réalisation, une deuxième face de la région centrale du guide d'ondes, opposée à la première face, est séparée de la région en ledit matériau à changement de phase par une distance comprise entre 0 et 550 nm.

Selon un mode de réalisation, la région centrale du guide d'ondes présente :
- une largeur comprise entre 200 nm et 2 µm ; et
- une hauteur comprise entre 200 et 400 nm.

Selon un mode de réalisation, les première et deuxième électrodes de conduction font partie d'un élément d'antenne d'une cellule de réseau transmetteur ou de réseau réflecteur.

Selon un mode de réalisation, la région centrale du guide d'ondes est interposée entre les première et deuxième électrodes de conduction, d'une part, et la région en ledit matériau à changement de phase, d'autre part.

Selon un mode de réalisation, la région en ledit matériau à changement de phase est interposé entre les première et deuxième électrodes de conduction, d'une part, et la région centrale du guide d'ondes, d'autre part.

Selon un mode de réalisation, ledit matériau à changement de phase est :
- un matériau chalcogénure, de préférence le tellurure de germanium, le tellurure d'antimoine ou le germanium-antimoine-tellure ; ou
- le dioxyde de vanadium.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

la figure 1A et la figure 1B sont des vues schématiques et partielles, respectivement de dessus et en coupe selon le plan BB de la figure 1A, illustrant un exemple de commutateur à base d'un matériau à changement de phase ;

la figure 2A et la figure 2B sont des vues schématiques et partielles, respectivement de dessus et en coupe selon le plan BB de la figure 2A, illustrant un exemple de commutateur à base d'un matériau à changement de phase selon un mode de réalisation ; et

la figure 3 est un graphique illustrant des variations de puissance optique absorbée par une région en matériau à changement de phase du commutateur des figures 2A et 2B le long d'une direction de propagation, dans un guide d'ondes, d'un signal optique d'actionnement du commutateur.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les circuits de commande des commutateurs à base d'un matériau à changement de phase et les applications dans lesquelles peuvent être prévus de tels commutateurs n'ont pas été détaillés, les modes de réalisation et variantes décrits étant compatibles avec les circuits de commande des commutateurs à base d'un matériau à changement de phase usuels et avec les applications usuelles mettant en œuvre des commutateurs à base d'un matériau à changement de phase.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais « coupled ») entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes « avant », « arrière », « haut », « bas », « gauche », « droite », etc., ou relative, tels que les termes « dessus », « dessous », « supérieur », « inférieur », etc., ou à des qualificatifs d'orientation, tels que les termes « horizontal », « vertical », etc., il est fait référence, sauf précision contraire, à l'orientation des figures.

Sauf précision contraire, les expressions « environ », « approximativement », « sensiblement », et « de l'ordre de » signifient à 10 % ou à 10° près, de préférence à 5 % ou à 5° près.

Dans la description qui suit, les qualificatifs « isolant » et « conducteur » signifient respectivement, sauf précision contraire, électriquement isolant et électriquement conducteur.

Sauf précision contraire, l'expression « en contact avec » signifie « en contact mécanique avec ».

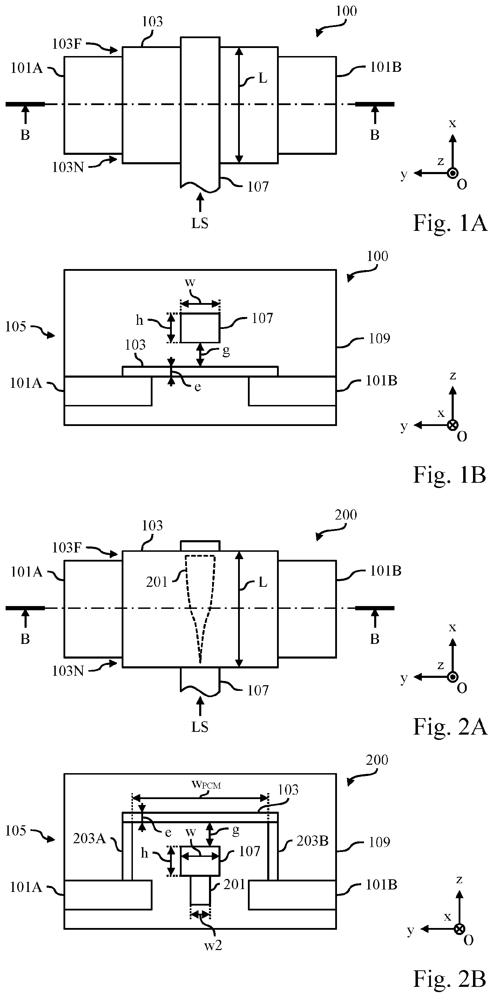

La figure 1A et la figure 1B sont des vues schématiques et partielles, respectivement de dessus et en coupe selon le plan BB de la figure 1A, illustrant un exemple de commutateur 100 à base d'un matériau à changement de phase. Dans l'exemple illustré, le plan BB de la figure 1A est un plan vertical parallèle à une direction de conduction du commutateur 100.

En figures 1A et 1B, la direction de conduction du commutateur 100 est parallèle à un axe horizontal Oy, et le plan BB est parallèle à un plan vertical Oyz orthogonal à un axe Ox.

Dans l'exemple représenté, le commutateur 100 comprend des électrodes de conduction 101A et 101B. Les électrodes de conduction 101A et 101B du commutateur 100 sont par exemple destinées à être connectées à un circuit de communication radiofréquence, non détaillé sur les figures. Les électrodes de conduction 101A et 101B sont en un matériau électriquement conducteur, par exemple un métal, par exemple le cuivre ou l'aluminium, ou en un alliage métallique. Par ailleurs, les électrodes de conduction 101A et 101B peuvent présenter une structure monocouche ou multicouche.

Bien que cela n'ait pas été détaillé en figures 1A et 1B afin de ne pas surcharger le dessin, les électrodes de conduction 101A et 101B du commutateur 100 sont par exemple situées sur et en contact avec une face supérieure d'une couche électriquement isolante, par exemple en dioxyde de silicium (SiO₂), revêtant un substrat. À titre d'exemple, le substrat est dans ce cas une plaquette ou un morceau de plaquette en un matériau semiconducteur, par exemple le silicium. Les électrodes de conduction 101A et 101B du commutateur 100 font par exemple partie d'un élément d'antenne d'une cellule de réseau transmetteur (« transmitarray », en anglais) ou réflecteur (« reflectarray », en anglais).

Dans l'exemple illustré, le commutateur 100 comprend en outre une région 103 en un matériau à changement de phase reliant les électrodes de conduction 101A et 101B. Bien que cela n'ait pas été détaillé sur les figures, la région 103 en matériau à changement de phase revêt par exemple une face supérieure d'une autre couche électriquement isolante, par exemple en dioxyde de silicium, s'étendant latéralement entre les électrodes 101A et 101B, la couche électriquement isolante affleurant par exemple les faces supérieures des électrodes 101A et 101B. Dans l'exemple représenté, la région 103 en matériau à changement de phase se prolonge sur et en contact avec une partie de la face supérieure de chaque électrode de conduction 101A, 101B. Dans l'exemple illustré, la région 103 en matériau à changement de phase présente une largeur L. La largeur L de la région 103 correspond plus précisément à la dimension latérale de la région 103 mesurée le long de l'axe Ox. La largeur L de la région 103 en matériau à changement de phase est par exemple de l'ordre de quelques dizaines de micromètres, par exemple comprise entre 10 et 100 µm, par exemple entre 30 et 100 µm. À titre d'exemple, la région 103 en matériau à changement de phase présente une épaisseur e de l'ordre de 100 nm.

À titre d'exemple, la région 103 du commutateur 100 est en un matériau dit « chalcogénure », c'est-à-dire un matériau ou un alliage comprenant au moins un élément chalcogène, par exemple un matériau de la famille du tellurure de germanium (GeTe), du tellurure d'antimoine (SbTe) ou du germanium-antimoine-tellure (GeSbTe, communément désigné par l'acronyme « GST »). À titre de variante, la région 103 est en dioxyde de vanadium (VO₂).

De manière générale, les matériaux à changement de phase sont des matériaux capables d'alterner, sous l'effet d'une variation de température, entre une phase cristalline et une phase amorphe, la phase amorphe présentant une résistance électrique supérieure à celle de la phase cristalline. Dans le cas du commutateur 100, ce phénomène est exploité pour obtenir un état bloqué, empêchant la circulation d'un courant entre les électrodes de conduction 101A et 101B, lorsque le matériau de la région 103 située entre les électrodes de conduction est dans la phase amorphe, et un état passant, permettant la circulation du courant entre les électrodes de conduction 101A et 101B, lorsque le matériau de la région 103 est dans la phase cristalline.

Dans l'exemple représenté, le commutateur 100 comprend en outre un guide d'ondes 105 situé en vis-à-vis de la région 103 en matériau à changement de phase et s'étendant latéralement le long d'une direction principale sensiblement orthogonale à la direction de conduction du commutateur 100. En figures 1A et 1B, le guide d'ondes 105 du commutateur 100 s'étend parallèlement à l'axe Ox. Le guide d'ondes 105 comporte par exemple une première extrémité située en vis-à-vis d'une face supérieure de la région 103 en matériau à changement de phase et une deuxième extrémité, opposée à la première extrémité, destinée à être illuminée par une source laser LS. La source laser LS émet par exemple un rayonnement constituant un signal optique de commande du commutateur 100. Le rayonnement laser LS émis par la source se propage par exemple dans le guide d'ondes 105 sous la forme d'une onde optique. À titre d'exemple, le rayonnement émis par la source laser LS présente une polarisation transverse magnétique (TM) ou une polarisation transverse électrique (TE).

Dans l'exemple illustré, le guide d'ondes 105 comprend une région centrale 107, ou âme, entourée d'une région périphérique 109 électriquement isolante. Dans l'exemple illustré, la région centrale 107 du guide d'ondes 105 s'étend parallèlement à l'axe Ox. La région centrale 107 et la région périphérique 109 du guide d'ondes 105 sont en des matériaux choisis de sorte à obtenir un contraste d'indices de réfraction permettant de confiner et guider un mode optique d'intérêt émis par la source laser LS. Le matériau de la région centrale 107 du guide d'ondes 105 présente par exemple un indice de réfraction strictement supérieur à celui de la région périphérique 109. À titre d'exemple, la région centrale 107 du guide d'ondes 105 est en nitrure de silicium et la région périphérique 109 est en dioxyde de silicium.

Le plan BB de la figure 1A est sensiblement orthogonal à une direction de propagation du rayonnement laser dans le guide d'ondes 105. La direction de propagation du rayonnement laser dans le guide d'ondes 105 est, dans l'exemple illustré, parallèle à l'axe Ox. Dans l'exemple représenté, la région périphérique 109 du guide d'ondes 105 revêt les faces de la région centrale 107 parallèles à la direction de propagation du rayonnement laser (les faces latérales, inférieure et supérieure de la région centrale 107 du guide d'ondes 105 parallèles à l'axe Ox, en figures 1A et 1B). La région périphérique 109 est plus précisément en contact avec les faces latérales, inférieure et supérieure de la région centrale 107. Dans cet exemple, une partie de la région périphérique 109 du guide d'ondes 105 s'étend verticalement, le long de l'axe vertical Oz orthogonal aux axes horizontaux Ox et Oy, depuis une face de la région centrale 107 située en regard de la région 103 en matériau à changement de phase (la face inférieure de la région centrale 107 du guide d'ondes 105, dans l'orientation de la figure 1B) jusqu'à une face de la région 103 en matériau à changement de phase opposée aux électrodes de conduction 101A et 101B (la face supérieure de la région 103 en matériau à changement de phase, dans l'orientation de la figure 1B).

Dans l'exemple représenté, la région centrale 107 présente, en vue en coupe selon le plan BB orthogonal à la direction de propagation du rayonnement laser dans le guide d'ondes 105, une section de forme sensiblement rectangulaire. À titre d'exemple, la région centrale 107 présente, en vue en coupe selon le plan BB, une largeur w (le long de l'axe Ox) égale à environ 300 nm et une hauteur h (le long de l'axe Oz) égale à environ 350 nm. Par ailleurs, la région centrale 107 du guide d'ondes 105 est séparée de la région 103 en matériau à changement de phase par une distance g. Dans cet exemple, la distance g équivaut à une épaisseur de la partie de la région périphérique 109 interposée entre la région centrale 107 du guide d'ondes 105 et la région 103 en matériau à changement de phase. À titre d'exemple, la distance g est égale à environ 300 nm.

Le guide d'ondes 105 est par exemple de type monomode, c'est-à-dire qu'il est adapté à confiner et guider un seul mode optique pour chaque type de polarisation. Le guide d'ondes 105 est par exemple plus précisément adapté à confiner et guider un seul mode optique choisi parmi un mode transverse électrique d'ordre zéro (TE0), parallèle à l'axe Oy, et un mode transverse magnétique d'ordre zéro (TM0), parallèle à l'axe Oz. Du fait que les modes TE0 et TM0 sont orthogonaux, ils ne peuvent pas se coupler mutuellement dans le guide d'ondes 105. Le choix du mode confiné et guidé par le guide d'ondes 105, entre le mode TE0 et le mode TM0, est déterminé par la polarisation de la source laser LS. Ainsi, dans un cas où la source laser LS émet un rayonnement présentant une polarisation transverse magnétique TM, le guide d'ondes 105 est adapté à confiner et guider le mode transverse magnétique d'ordre zéro TM0 uniquement.

Du côté de son extrémité destinée à être illuminée par la source laser LS, le guide d'ondes 105 comprend par exemple un élément de couplage d'entrée, aussi appelé surface d'entrée du guide d'ondes 105. Du côté de son extrémité située en vis-à-vis de la région 103 en matériau à changement de phase, le guide d'ondes 105 peut en outre comprendre un élément de couplage de sortie, aussi appelé surface de sortie du guide d'ondes 105. L'élément de couplage d'entrée peut présenter une structure, par exemple un réseau de diffraction présentant une structure de Bragg ou toute autre structure de couplage, permettant de capter le rayonnement émis par la source laser LS et de propager ce rayonnement jusqu'à la surface de sortie.

Par ailleurs, la surface de sortie du guide d'ondes 105 peut présenter une structure permettant de réémettre le rayonnement propagé depuis la surface d'entrée vers la région 103 en matériau à changement de phase. Bien que cela n'ait pas été détaillé en figures 1A et 1B, la surface de sortie du guide d'ondes 105 peut présenter une structure identique ou analogue à celle de sa surface d'entrée.

De manière générale, les surfaces d'entrée et de sortie du guide d'ondes 105 permettent respectivement, dans l'exemple représenté, de recevoir et de transmettre un rayonnement, ou onde optique, selon une direction orthogonale à la direction de propagation du rayonnement, ou de l'onde optique, à l'intérieur du guide d'ondes 105, par exemple une direction parallèle à l'axe Oz. À titre de variante, au moins une surface, parmi les surfaces d'entrée et de sortie du guide d'ondes 105, peut présenter une structure permettant respectivement de recevoir ou de transmettre un rayonnement, ou onde optique, selon une direction parallèle à la direction de propagation du rayonnement, ou de l'onde optique, à l'intérieur du guide d'ondes 105 (parallèle à l'axe Ox, dans cet exemple).

Pour faire basculer le commutateur 100 de l'état bloqué à l'état passant, la région 103 est chauffée, à l'aide de la source laser LS, par l'intermédiaire du guide d'ondes 105, à une température T1 et pendant une durée d1. La température T1 et la durée d1 sont choisies de sorte à provoquer un changement de phase du matériau de la région 103 depuis la phase amorphe vers la phase cristalline. À titre d'exemple, la température T1 est supérieure à une température de cristallisation et inférieure à une température de fusion du matériau à changement de phase et la durée d1 est comprise entre 10 et 100 ns.

À l'inverse, pour faire basculer le commutateur 100 de l'état passant à l'état bloqué, la région 103 est chauffée, à l'aide de la source laser LS, par l'intermédiaire du guide d'ondes 105, à une température T2, supérieure à la température T1, et pendant une durée d2, inférieure à la durée d1. La température T2 et la durée d2 sont choisies de sorte à provoquer un changement de phase du matériau de la région 103 depuis la phase cristalline vers la phase amorphe. À titre d'exemple, la température T2 est supérieure à la température de fusion du matériau à changement de phase et la durée d2 est de l'ordre de 10 ns.

Un inconvénient du commutateur 100 tient au fait que l'onde optique se propageant dans le guide d'ondes 107 n'est pas absorbée de façon homogène dans la région 103 en matériau à changement de phase le long de la direction de propagation de l'onde optique dans le guide d'ondes 105 (le long de l'axe Ox, dans cet exemple). Dans l'exemple du commutateur 100, l'onde optique est majoritairement absorbée par une première partie 103N de la région 103 en matériau à changement de phase proche de la source laser LS, l'absorption de l'onde optique étant plus faible dans une deuxième partie 103F de la région 103 en matériau à changement de phase, opposée à la première partie 103N, plus éloignée de la source laser LS que la partie 103N. L'absorption optique de l'onde par la région 103 en matériau à changement de phase suit plus précisément une exponentielle décroissante depuis la partie 103N de la région 103 jusqu'à la partie 103F.

Ainsi, lors d'une phase d'activation du commutateur 100, la puissance optique absorbée par la deuxième partie 103F de la région 103 peut s'avérer insuffisante pour provoquer un changement de phase du matériau dans la partie 103F. Dans le cas où l'on souhaite faire basculer le commutateur 100 de l'état passant à l'état bloqué, cela peut empêcher la deuxième partie 103F de la région 103 de changer de phase depuis la phase cristalline vers la phase amorphe, autorisant ainsi, de façon indésirable, le passage d'un courant de fuite entre les électrodes de conduction 101A et 101B du commutateur 100. Ce phénomène est d'autant plus susceptible de se produire que la largeur L de la région 103 est importante.

Les inventeurs se sont aperçus que le phénomène provient du fait que le mode transverse magnétique TM du signal laser d'activation du commutateur 100 confiné et guidé par le guide d'ondes 105 est fortement absorbé par le matériau à changement de phase de la région 103, conduisant ainsi à un échauffement de la partie 103N bien supérieur à celui observé dans la partie 103F. Pour pallier ce problème, la géométrie du guide d'ondes 105 pourrait être modifiée pour confiner et guider uniquement le mode transverse électrique TE, plus faiblement absorbé par le matériau à changement de phase de la région 103 que le mode transverse magnétique TM. À titre d'exemple, le mode transverse magnétique TM présente des pertes, liées à l'absorption par le matériau à changement de phase de la région 103, de l'ordre de 2 500 dB.cm⁻¹, contre environ 500 dB.cm⁻¹ pour le mode transverse électrique TE. Toutefois, pour des valeurs de puissance laser équivalentes, cela ne permettrait pas d'obtenir un échauffement suffisant de la région 103 pour provoquer un changement de phase. De manière plus générale, tant en mode transverse électrique TE qu'en mode transverse magnétique TM, l'absorption optique suit une loi de type exponentielle décroissante pour cette configuration de guide. Toutefois, il serait préférable que l'absorption suive une loi linéaire pour permettre de modifier l'état du matériau à changement de phase de la région 103.

Par ailleurs, des commutateurs à base d'un matériau à changement de phase à actionnement optique dit « direct » ont été proposés. Dans ces commutateurs, la région en matériau à changement de phase est par exemple irradiée par une source laser focalisée sur ladite région, les commutateurs étant par exemple dépourvus de guide d'ondes entre la source laser et la région en matériau à changement de phase.

Un tel commutateur est décrit dans l'article de A. Crunteanu et al. intitulé « Optical Switching of GeTe Phase Change Materials for High-Frequency Applications » et publié en 2017 suite à la conférence « IEEE MTT-S International Microwave Workshop Series on Advanced Materials and Processes for RF and THz Applications (IMWS-AMP) ». Dans cet article, une source laser à base de fluorure de krypton (KrF) émet un rayonnement présentant une longueur d'onde égale à environ 248 nm, par exemple sous forme d'impulsions, pour provoquer des transitions d'une région en matériau à changement de phase d'un commutateur entre les phases amorphe et cristalline. Une impulsion présentant une fluence de l'ordre de 90 mJ.cm⁻² est par exemple utilisée pour obtenir une transition depuis la phase amorphe vers la phase cristalline. En outre, une autre impulsion présentant une fluence de l'ordre de 185 mJ.cm⁻² est par exemple utilisée pour obtenir une transition depuis la phase cristalline vers la phase amorphe.

Les commutateurs à base d'un matériau à changement de phase à actionnement optique direct présentent toutefois des inconvénients. Ces commutateurs sont notamment incompatibles avec des structures de composant encapsulé. Par ailleurs, chaque commutateur requiert l'utilisation d'une source laser dédiée. Cela empêche ou complexifie grandement la réalisation de composants électroniques intégrés comprenant plusieurs commutateurs commandables individuellement.

La figure 2A et la figure 2B sont des vues schématiques et partielles, respectivement de dessus et en coupe selon le plan BB de la figure 2A, illustrant un exemple de commutateur 200 à base d'un matériau à changement de phase selon un mode de réalisation.

Le commutateur 200 des figures 2A et 2B comprend des éléments communs avec le commutateur 100 des figures 1A et 1B. Ces éléments communs ne seront pas détaillés à nouveau ci-après. Le commutateur 200 des figures 2A et 2B diffère du commutateur 100 des figures 1A et 1B en ce que le commutateur 200 comprend en outre une région 201 située dans la région périphérique 109 du guide d'ondes 105, à l'aplomb d'une face de la région centrale 107 du guide d'ondes 105 opposée à la région 103 en matériau à changement de phase.

Par ailleurs, la région centrale 107 du guide d'ondes 105 du commutateur 200 est interposée verticalement entre les électrodes de conduction 101A et 101B, d'une part, et la région 103 en matériau à changement de phase, d'autre part. Toutefois, cet exemple n'est pas limitatif. À titre de variante, le commutateur 200 peut présenter une structure analogue à celle du commutateur 100, dans laquelle la région 103 en matériau à changement de phase est interposée verticalement entre les électrodes de conduction 101A et 101B, d'une part, et la région centrale 107 du guide d'ondes 105, d'autre part. Dans cette variante, la région centrale 107 du guide d'ondes 105 est alors interposée verticalement entre la région 103 en matériau à changement de phase et la région 201.

Dans l'exemple illustré, la région 103 en matériau à changement de phase est reliée aux électrodes de conduction 101A et 101B par des vias conducteurs 203A et 203B, respectivement. Dans l'orientation de la figure 2B, les vias 203A et 203B s'étendent depuis les faces supérieures des électrodes de conduction 101A et 101B, respectivement, jusqu'à deux zones opposées de la face inférieure de la région 103 en matériau à changement de phase. Les vias 203A et 203B sont par exemple séparés par une distance w_{PCM} correspondant par exemple à une largeur d'une zone dite « active » de la région 103 en matériau à changement de phase, c'est-à-dire une zone de la région 103 dans laquelle se produit effectivement le changement de phase lorsque le signal optique de commande du commutateur 200 est transmis par le guide d'ondes 105.

Dans l'exemple représenté, la région 201 s'étend dans la région périphérique 109 du guide d'ondes 105 depuis la face de la région centrale 107 opposée à la région 103. Dans l'orientation de la figure 2B, la région centrale 107 du guide d'ondes 105 est située sur et en contact avec la face supérieure de la région 201. Dans l'exemple illustré, la région périphérique 109 du guide d'ondes 105 revêt toutes les faces de la région 201 à l'exception de sa face supérieure. La région périphérique 109 est plus précisément en contact avec toutes les faces de la région 201 à l'exception de sa face supérieure.

Par ailleurs, dans cet exemple, la région périphérique 109 du guide d'ondes 105 revêt les faces de la région centrale 107 parallèles à la direction de propagation du signal optique de commande du commutateur 200 (les faces latérales, inférieure et supérieure de la région centrale 107 du guide d'ondes 105 parallèles à l'axe Ox, en figures 2A et 2B) à l'exception d'au moins une partie de sa face inférieure située en contact avec la région 201. Dans l'exemple représenté, la région 109 est plus précisément en contact avec lesdites faces de la région 107.

Cet exemple n'est toutefois pas limitatif et la région 201 peut, à titre de variante, être séparée de la région centrale 107 du guide d'ondes 105 par une partie de la région périphérique 109 s'étendant verticalement, le long de l'axe Oz, depuis une face de la région centrale 107 située en regard de la région 201 (la face inférieure de la région centrale 107, dans l'orientation de la figure 2B) jusqu'à une face de la région 201 située en regard de la région centrale 107 (la face supérieure de la région 201, dans l'orientation de la figure 2B). Dans cette variante, la région périphérique 109 du guide d'ondes 105 revêt, ou est plus précisément en contact avec, toutes les faces de la région 201 et les faces latérales, inférieure et supérieure de la région centrale 107 du guide d'ondes 105 parallèles à l'axe Ox.

Selon un mode de réalisation, la région 201 est en un matériau présentant un indice de réfraction strictement inférieur à celui de la région périphérique 109 du guide d'ondes 105. La région 201 est par exemple une cavité formée dans la région périphérique 109 du guide d'ondes 105. De manière générale, la cavité est au moins partiellement remplie d'une ou plusieurs substances solides, liquides ou gazeuses présentant un indice de réfraction inférieur à celui de la région périphérique 109 du guide d'ondes 105. La cavité est par exemple au moins partiellement remplie d'au moins une substance choisie parmi :
- un gaz, par exemple le dioxyde de carbone, ou un mélange gazeux, par exemple de l'air ;
- un liquide, par exemple de l'acétone ; et/ou
- la glace.

La présence de la région 201 présentant un indice de réfraction inférieur à celui de la région périphérique 109 du guide d'ondes 105 permet d'augmenter l'absorption du signal optique de commande du commutateur 200 par le matériau à changement de phase de la région 103. Plus la région 201 présente une largeur w2 (le long de l'axe Ox) importante et plus l'absorption, par le matériau à changement de phase de la région 103, du signal optique de commande du commutateur 200 est importante. Dans l'exemple représenté, la région 201 présente, en vue de dessus, une forme fuselée s'évasant, autrement dit s'élargissant, le long de la direction de propagation du signal optique de commande du commutateur 200. Plus précisément, dans cet exemple, la largeur w2 de la région 201 est plus faible au voisinage de la partie 103N de la région 103 qu'au voisinage de la partie 103F. Dans l'exemple illustré, la largeur w2 de la région 201 croît de façon monotone depuis la partie 103N jusqu'à la partie 103F.

Le tableau ci-dessous fournit des exemples de valeurs minimales (min) et maximales (max), en nanomètres (nm) de différentes dimensions du commutateur 200, en l'espèce : la hauteur h et la largeur w de la région centrale 107 du guide d'ondes 105, la distance g séparant la région centrale 107 du guide d'ondes 105 de la région 103 en matériau à changement de phase, et la largeur w2 de la région 201.

**[Table 1]**

| Dimension | Valeur min (nm) | Valeur max (nm) |
|---|---|---|
| h | 200 | 400 |
| w | 200 | 2 000 |
| g | 0 | 550 |
| w2 | 0 | w_{PCM} |

La valeur de la hauteur h est par exemple choisie de sorte à permettre de guider un unique mode transverse magnétique TM, par exemple le mode TM0, sans produire d'harmoniques. La valeur de la largeur w est par exemple choisie de sorte à permettre de guider le signal optique de commande du commutateur 200 sans exciter des modes d'ordres supérieurs. La valeur de la distance g, qui sépare la région 103 en matériau à changement de phase d'une face de la région centrale 107 du guide d'ondes 105 opposée à la région 201, est par exemple choisie de sorte à permettre d'ajuster un niveau d'absorption initial, c'est-à-dire au voisinage de la partie 103N de la région 103, en l'absence de la région 201. Les valeurs de la largeur w2 sont par exemple choisies de sorte à permettre de contrôler la position du mode de propagation optique.

Le tableau ci-dessous fournit, à titre d'exemple, des valeurs de la largeur w2 de la région 201 en fonction de la position le long de l'axe Ox, la coordonnée 0 correspondant à la position de la face latérale de la région 103 située du côté de la partie 103N. Dans l'exemple ci-dessous, les dimensions h, w, g et L sont respectivement égales à environ 300 nm, 600 nm, 330 nm et 20 µm.

**[Table 2]**

| Position (µm) | w2 (µm) |
|---|---|
| 0 | 0 |
| 5 | 0,2 |
| 10 | 0,5 |
| > 12 | 1 |

Le tableau ci-dessous fournit, à titre d'exemple, des valeurs de la largeur w2 de la région 201 en fonction de la position le long de l'axe Ox. Dans l'exemple ci-dessous, les dimensions h, w, g et L sont respectivement égales à environ 400 nm, 200 nm, 350 nm et 30 µm.

**[Table 3]**

| Position (µm) | w2 (µm) |
|---|---|
| 0 | 0 |
| 6 | 0, 1 |
| 9,7 | 0,2 |
| 13 | 0,5 |
| > 14 | 2 |

Le tableau ci-dessous fournit, à titre d'exemple, des valeurs de la largeur w2 de la région 201 en fonction de la position le long de l'axe Ox. Dans l'exemple ci-dessous, les dimensions h, w, g et L sont respectivement égales à environ 200 nm, 2 µm, 550 nm et 90 µm.

**[Table 4]**

| Position (µm) | w2 (µm) |
|---|---|
| 0 | 0 |
| 11 | 0, 1 |
| 16 | 0,2 |
| 20 | 0,3 |
| 43 | 1 |
| 52 | 1,2 |
| > 69 | 3 |

Dans les exemples ci-dessus, l'épaisseur e de la région 103 en matériau à changement de phase est égale à environ 100 nm.

Les exemples fournis ci-dessus ne sont toutefois pas limitatifs, et la personne du métier est capable de définir les valeurs des dimensions h, w, g et w2 en fonction, entre autres, de la largeur L de la région 103 en matériau à changement de phase. Des outils de simulation numérique peuvent par exemple être utilisés à cette fin.

Un avantage du commutateur 200 exposé ci-dessus en relation avec les figures 2A et 2B tient au fait que la présence de la région 201 permet de faire en sorte que le signal laser de commande du commutateur 200 soit absorbé de façon sensiblement uniforme par le matériau à changement de phase de la région 103. Plus précisément, dans le cas du commutateur 200, le mode transverse magnétique TM est plus faiblement absorbé à l'aplomb de la partie 103N de la région 103 et plus fortement absorbé à l'aplomb de la partie 103F de la région 103. À titre d'exemple, les pertes du mode TM sont égales à environ 500 dB.cm⁻¹ au voisinage de la partie 103N et égales à environ 2 500 dB.cm⁻¹ au voisinage de la partie 103F. Cela permet d'éviter, par rapport au commutateur 100 des figures 1A et 1B, qu'une partie de la région 103 en matériau à changement de phase, par exemple la partie 103F la plus éloignée de la source laser LS, ne change pas de phase lors de la commande du commutateur.

L'intégration du commutateur 200 décrit précédemment s'avère par exemple particulièrement avantageuse dans des dispositifs électroniques de communication radiofréquence. En effet, pour ce type d'application, il est très intéressant de disposer de commutateurs dont la largeur L est grande, par exemple de l'ordre de quelques dizaines de micromètres, dans la mesure où cela permet de limiter l'apparition de phénomènes de capacité parasite et de commuter des signaux électriques plus intenses que dans le cas de commutateurs dont la largeur L est plus faible. Toutefois, cet exemple n'est pas limitatif, et la personne du métier peut bien entendu tirer profit des avantages du commutateur 200 dans de nombreuses applications autres que les applications de communication radiofréquence.

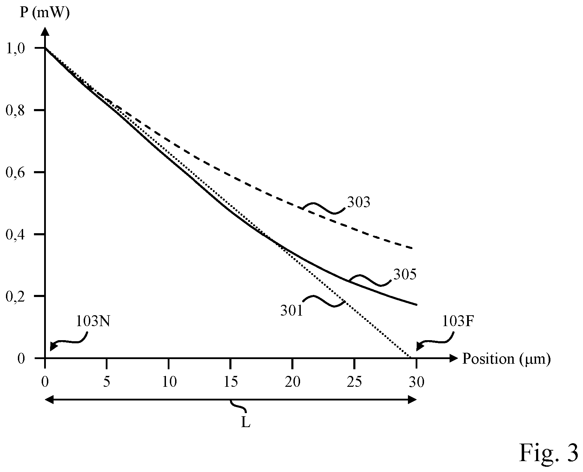

La figure 3 est un graphique illustrant des variations de puissance optique P (en milliwatts, mW) absorbée par la région 103 en matériau à changement de phase du commutateur 200 en fonction d'une position (en micromètres, µm) mesurée le long de la direction Ox de propagation, dans le guide d'ondes 105, du signal optique d'actionnement du commutateur 200.

Dans l'exemple représenté, une courbe 301 illustre un cas idéal dans lequel la puissance optique P est absorbée de façon linéaire dans le matériau à changement de phase de la région 103. Ce cas conduit à un échauffement uniforme, ou homogène, du matériau à changement de phase de la région 103.

En figure 3, une autre courbe 303 illustre un cas d'un commutateur analogue au commutateur 200 mais dépourvu de la région 201. Dans ce cas, la distance g permet à la région 103 en matériau à changement de phase d'absorber, dans les premiers micromètres depuis la partie 103N, une puissance optique sensiblement égale à celle qui est absorbée dans le cas idéal illustré par la courbe 301. Toutefois, dans les derniers micromètres situés au voisinage de la partie 103F, la puissance optique absorbée est supérieure à celle du cas idéal illustré par la courbe 301. Cela n'est pas souhaitable, car le matériau à changement de phase de la région 103 risque d'être endommagé par cet excès de puissance optique.

Dans l'exemple représenté, une autre courbe 305 illustre le cas du commutateur 200, dans lequel la distance g est sensiblement égale à celle du commutateur du cas de la courbe 303 et dans lequel la présence de la région 201 permet d'obtenir, dans la région 103 en matériau à changement de phase, un profil d'absorption de la puissance optique P très proche de celui du cas idéal illustré par la courbe 301. La courbe 305 correspond plus précisément à l'exemple décrit ci-dessus en relation avec le tableau [Table 3].

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, les dimensions e et L de la région 103 en matériau à changement de phase, les dimensions w et h de la région centrale 107 du guide d'ondes 105, la dimension w2 de la région 201 et la distance g peuvent être adaptées par la personne du métier à partir des indications de la présente description, par exemple en fonction de l'application visée.

Enfin, la mise en œuvre pratique des modes de réalisation et variantes décrits est à la portée de la personne du métier à partir des indications fonctionnelles données ci-dessus. En particulier, les modes de réalisation décrits ne se limitent pas aux exemples particuliers de matériaux et de dimensions mentionnés dans la présente description.

## Revendications

1. Commutateur (200) à base d'un matériau à changement de phase comprenant :
- une région (103) en ledit matériau à changement de phase reliant des première (101A) et deuxième (101B) électrodes de conduction du commutateur ;
- un guide d'ondes (105) situé à l'aplomb de la région (103) en ledit matériau à changement de phase et comprenant une région centrale (107) en un premier matériau présentant un premier indice de réfraction entourée d'une région périphérique (109) en un deuxième matériau présentant un deuxième indice de réfraction inférieur au premier indice de réfraction, le guide d'ondes (105) étant adapté à transmettre un signal optique de commande du commutateur (200) ; et
- une région (201) en un troisième matériau présentant un troisième indice de réfraction inférieur au deuxième indice de réfraction et située dans la région périphérique (109) du guide d'ondes (105) à l'aplomb d'une première face de la région centrale (107) du guide d'ondes (105) opposée à la région (103) en ledit matériau à changement de phase.

2. Commutateur (200) selon la revendication 1, dans lequel la région (201) en ledit troisième matériau s'étend depuis la première face de la région centrale (107) du guide d'ondes (105).

3. Commutateur (200) selon la revendication 1 ou 2, dans lequel la région (201) en ledit troisième matériau est une cavité au moins partiellement remplie d'une ou plusieurs substances solides, liquides ou gazeuses, de préférence une cavité remplie d'air.

4. Commutateur (200) selon l'une quelconque des revendications 1 à 3, dans lequel la région (201) en ledit troisième matériau présente, en vue de dessus, une forme fuselée s'évasant le long d'une direction (Ox) de propagation d'un signal optique de commande du commutateur.

5. Commutateur (200) selon l'une quelconque des revendications 1 à 4, dans lequel la région (103) en ledit matériau à changement de phase présente une largeur (L) de l'ordre d'une ou plusieurs dizaines de micromètres, de préférence comprise entre 10 et 100 µm, plus préférentiellement comprise entre 30 et 100 µm.

6. Commutateur (200) selon l'une quelconque des revendications 1 à 5, dans lequel une deuxième face de la région centrale (107) du guide d'ondes (105), opposée à la première face, est séparée de la région (103) en ledit matériau à changement de phase par une distance (g) comprise entre 0 et 550 nm.

7. Commutateur (200) selon l'une quelconque des revendications 1 à 6, dans lequel la région centrale (107) du guide d'ondes (105) présente :
- une largeur (w) comprise entre 200 nm et 2 µm ; et
- une hauteur (h) comprise entre 200 et 400 nm.

8. Commutateur (200) selon l'une quelconque des revendications 1 à 7, dans lequel les première (101A) et deuxième (101B) électrodes de conduction font partie d'un élément d'antenne d'une cellule de réseau transmetteur ou de réseau réflecteur.

9. Commutateur (200) selon l'une quelconque des revendications 1 à 8, dans lequel la région centrale (107) du guide d'ondes (105) est interposée entre les première (101A) et deuxième (101B) électrodes de conduction, d'une part, et la région (103) en ledit matériau à changement de phase, d'autre part.

10. Commutateur (200) selon l'une quelconque des revendications 1 à 8, dans lequel la région (103) en ledit matériau à changement de phase est interposé entre les première (101A) et deuxième (101B) électrodes de conduction, d'une part, et la région centrale (107) du guide d'ondes (105), d'autre part.

11. Commutateur (200) selon l'une quelconque des revendications 1 à 10, dans lequel ledit matériau à changement de phase est :
- un matériau chalcogénure, de préférence le tellurure de germanium, le tellurure d'antimoine ou le germanium-antimoine-tellure ; ou
- le dioxyde de vanadium.
